# EUROPEAN PATENT SPECIFICATION

(11) **EP 3 144 979 B1**
(45) Date of publication and mention of the grant of the patent: **08.05.2024**
(21) Application number: 16178410.3
(22) Date of filing: 07.07.2016
(51) Int. Cl.: H01L 31/0687, H01L 31/0693, H01L 31/0304, H01L 31/18, H01L 29/885

(54) **ANTIMONIDE-BASED HIGH BANDGAP TUNNEL JUNCTION FOR SEMICONDUCTOR DEVICES**
ANTIMONIDBASIERTER TUNNELÜBERGANG MIT HOHER BANDLÜCKE FÜR HALBLEITERBAUELEMENTE
JONCTION À EFFET TUNNEL À GRANDE BANDE INTERDITE REPOSANT SUR L'UTILISATION D'ANTIMONIURE POUR DISPOSITIFS À SEMI-CONDUCTEUR

(30) Priority: 21.09.2015 US 201514860214
(43) Date of publication of application: 22.03.2017
(73) Proprietor: The Boeing Company, Arlington, VA 22202 (US)
(72) Inventor: CHIU, Philip T., CHICAGO, IL, 60606-1596 (US); HADDAD, Moran, CHICAGO, IL, 60606-1596 (US); KING, Richard R., CHICAGO, IL, 60606-1596 (US)
(74) Representative: Plasseraud IP

(56) References cited:
- CN-A- 102 832 285
- US-A- 5 019 177
- US-A- 5 679 963
- US-A1- 2005 253 164
- US-A1- 2012 125 392
- TIMMONS M L ET AL: "GaAsSb and AlGaAsSB tunnel diodes", JOURNAL OF APPLIED PHYSICS, vol. 52, no. 2, February 1981 (1981-02), pages 1134-1135, XP000819834, ISSN: 0021-8979, DOI: 10.1063/1.328816
- AGERT C ET AL: "NOVEL DEVICE STRUCTURES FOR INFRARED SOLAR CELLS BASED ON GaSb: PN-HOMOJUNCTIONS, PN-HETEROJUNCTIONS, AND TANDEM CELLS", PROCEEDINGS OF THE 17TH EUROPEAN PHOTOVOLTAIC SOLAR ENERGY CONFERENCE, vol. CONF. 17, 22 October 2001 (2001-10-22), - 26 October 2001 (2001-10-26), pages 372-375, XP001139446, MUNICH, GERMANY ISBN: 978-3-936338-08-9
- TIMMONS M L ET AL: "AlGaAsSb/GaAsSb cascade solar cells", FIFTEENTH IEEE PHOTOVOLTAIC SPECIALISTS CONFERENCE,, 1 January 1981 (1981-01-01), pages 1289-1293, XP009193261,

## Description

### FIELD

The disclosed system and method relate to a semiconductor solar cell device and, more particularly, to a semiconductor device including a tunnel junction that has a n-doped tunnel layer and a p-doped tunnel layer, where the p-doped tunnel layer is constructed of aluminum gallium arsenide antimonide (AlGaAsSb).

### BACKGROUND

Wafer bonding technology may be used to monolithically join two materials with different lattice structures together. Wafer bonding technology has great potential. For example, joining gallium arsenide (GaAs) or indium phosphide (InP) based materials to other semiconductor materials may result in the integration of optical, photovoltaic, and electronic devices and enhance the performance of computers, solar cells, light emitting diodes and other electronic devices. In one specific example, a five-junction (5J) cell, which is created by bonding a three-junction (3J) GaAs-based cell with a two-junction (2J) InP-based cell, results in a terrestrial solar cell having an efficiency of about 39% and a space solar cell having an efficiency of about 36%.

One requirement for an InP-based multi-junction solar cell is a high transparency (which is also referred to as bandgap) tunnel junction. The tunnel junctions currently available that are employed in InP-based multi-junction solar cells may sometimes absorb high amounts of light, or have very low peak tunneling currents. For example, one type of tunnel junction that is currently available includes a n-doped InP layer and a p-doped InAlGaAs layer. However, this tunnel junction may not always be easy to grow. This is because compounds containing a large amount of indium, such as InAlGaAs, are typically challenging to dope p-type. Furthermore, this type of tunnel junction may have a limited peak tunnel current as well. In another approach, a tunnel junction having a p-doped gallium arsenide antimonide (GaAsSb) layer and a n-doped indium gallium arsenide (InGaAs) layer may be used. This tunnel junction has a relatively high peak tunnel current, but both layers of this tunnel junction may also absorb light that is intended for active junctions of the solar cell. Thus, there exists a need in the art for a semiconductor device having a tunnel junction that is relatively easy to dope, has a relatively high transparency, and a relatively high peak tunnel current. US 2005/253164 A1, according to its abstract, states a tunnel junction device with minimal hydrogen passivation of acceptors includes a p-type tunnel junction layer of a first semiconductor material doped with carbon. The first semiconductor material includes aluminum, gallium, arsenic and antimony. An n-type tunnel junction layer of a second semiconductor material includes indium, gallium, arsenic and one of aluminum and phosphorous. The junction between the p-type and an-type tunnel junction layers forms a tunnel junction. In document: TIMMONS M L ET AL, "GaAsSb and AlGaAsSB tunnel diodes", JOURNAL OF APPLIED PHYSICS, (198102), vol. 52, no. 2, doi:10.1063/1.328816, ISSN 0021-8979, pages 1134 - 1135, there are described GaAsSb and AlGaAsSb tunnel diodes. In document: AGERT C ET AL, "NOVEL DEVICE STRUCTURES FOR INFRARED SOLAR CELLS BASED ON GaSb: PN-HOMOJUNCTIONS, PN-HETEROJUNCTIONS, AND TANDEM CELLS", PROCEEDINGS OF THE 17TH EUROPEAN PHOTOVOLTAIC SOLAR ENERGY CONFERENCE, MUNICH, GERMANY, (20011022), vol. CONF. 17, ISBN 978-3-936338-08-9, pages 372 - 375, there are described structures for infrared solar cells based on GaSb. US 2012/125392 A1, according to its abstract, states a type-II tunnel junction that includes a p-doped AlGaInAs tunnel layer and a n-doped InP tunnel layer, in addition to solar cells that incorporate the high bandgap type-II tunnel junction between photovoltaic subcells. In document: TIMMONS M L ET AL, "AlGaAsSB/GaAsSb cascade solar cells",15th IEEE Photovoltaic specialists conference, 1981, p1289-1293 there are described AlGaAsSB/GaAsSb cascade solar cells. US 5 019 177 A, according to its abstract, states a single-crystal, monolithic, tandem, photovoltaic solar cell is described which includes (a) an InP substrate having upper and lower surfaces, (b) a first photoactive subcell on the upper surface of the InP substrate, and (c) a second photoactive subcell on the first subcell. The first photoactive subcell is GaInAsP of defined composition. The second subcell is InP. The two subcells are lattice matched. The solar cell can be provided as a two-terminal device or a three-terminal device. US 5 679 963 A, according to its abstract, states the incorporation of a pseudomorphic GaAsSb layer in a tunnel diode structure that affords a new degree of freedom in designing runnel junctions for p-n junction device interconnects. Previously only doping levels could be varied to control the tunneling properties. This disclosure uses the valence band alignment band of the GaAsSb with respect to the surrounding materials to greatly relax the doping requirements for tunneling. CN 102 832 285 A, according to its abstract, states a three-junction solar battery and a preparation method thereof. Indium phosphide (InP) is used as a growth substrate, a first subcell, a second subcell InP and a third subcell In₁₋ₓAlₓAs are formed on the InP growth substrate, a stress compensation quantum well is plugged in a base area of the InP subcell, so that the absorptive edge is effectively widened, the lattice matching between batteries can be effectively overcome through a gradient buffering layer, and the dislocation density is reduced.

### SUMMARY

The present invention is set out in the independent claims.

In one aspect, a semiconductor solar cell device according to claim 1 is disclosed.

In another aspect, a method of constructing a device according to claim 11 is disclosed.

Other objects and advantages of the disclosed method and system will be apparent from the following description, the accompanying drawings and the appended claims.

### BRIEF DESCRIPTION OF THE DRAWINGS

FIG. 1 is an illustration of an exemplary semiconductor device including the disclosed tunnel junction;
FIG. 2 is an illustration of an exemplary band offset diagram for the disclosed tunnel junction not forming part of the claimed present invention;
FIG. 3 is the band offset diagram shown in FIG. 2 after thermal equilibrium;
FIG. 4 is a graph illustrating measured current and voltage for an exemplary tunnel junction after annealing;
FIG. 5 is an illustration of an alternative embodiment of the semiconductor device shown in FIG. 1 having a different n-doped tunnel layer, not forming part of the claimed present invention;
FIG. 6 is an illustration of an exemplary band offset diagram for the disclosed tunnel junction shown in FIG. 5; and
FIG. 7 is the band offset diagram shown in FIG. 6 after thermal equilibrium.

### DETAILED DESCRIPTION

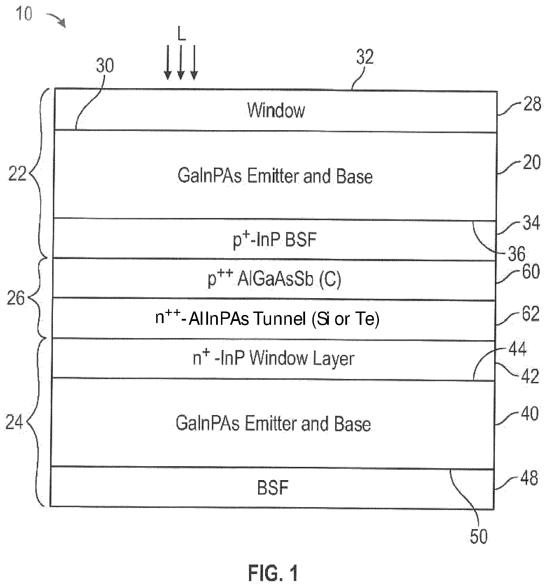

FIG. 1 is an illustration of an embodiment of the disclosed semiconductor device 10. According to the present invention, the semiconductor device 10 is an indium phosphide (InP)-based dual-junction solar cell, meaning the semiconductor device 10 includes two photovoltaic cells (which are also referred to as subcells). The semiconductor device 10 includes a first photovoltaic cell 22, a second photovoltaic cell 24, and the disclosed tunnel junction 26, which is located between the first photovoltaic cell 22 and the second photovoltaic cell 24. As explained in greater detail below, the tunnel junction 26 includes a n-doped tunnel layer and a p-doped tunnel layer, where the p-doped tunnel layer is constructed of aluminum gallium arsenide antimonide (AlGaAsSb). Furthermore, it should be appreciated that the tunnel junction 26 may be referred to as a p-n junction.

The first photovoltaic cell 22 includes a first emitter and base 20. The first emitter and base 20 is a material layer selected from group consisting of indium gallium arsenide phosphide (GaInPAs), aluminum arsenide antimonide (AlAsSb), aluminium gallium arsenide antimonide (AlGaAsSb), aluminum indium arsenide (AlInAs), indium phosphide (InP), aluminum gallium indium arsenide (AlGaInAs), gallium indium arsenide (GaInAs), or gallium arsenide antimonide (GaAsSb). In one embodiment, the first emitter and base 20 includes a separate emitter layer and base layer (not shown), where the emitter layer is nearest to incident light.

In the non-limiting embodiment as shown, the first photovoltaic cell 22 includes a bandgap of 1.1 eV. In another embodiment, the first photovoltaic cell 22 may include a bandgap of from about 0.73 to 2.45 eV. In yet another embodiment, the first photovoltaic cell 22 may include a bandgap of from about 1.0 to 1.1 eV and may be included in a three or more junction solar cell. The first photovoltaic cell 22 may be sensitive to a first-photoactive-subcell-layer wavelength. As used herein, the term wavelength may mean a single discrete wavelength, or, wavelength may include a range of wavelengths at which the layer material achieves a good light-to-electricity conversion efficiency.

The first photovoltaic cell 22 may also include a window layer 28. The window layer 28 may be disposed on a first side 30 of the first emitter and base 20, which would be positioned nearest to incident light L. As used herein, the relative terms top and bottom are used to indicate the surface nearest to and farthest from the incident light L, respectively. Also, when used to compare two layers, upper or above or overlying may refer to a layer closer to the sun, and lower or below or underlying may refer to a layer further from the sun or other source of illumination. The window layer 28 may be an InP, AlGaInAs, AlInAs, AlAsSb, AlGaAsSb, or a GalnPAs composition that provides bandgap energy greater than about 1.1 eV. The window layer 28 has two functions. The first function of the window layer 28 is to reduce minority-carrier recombination (i.e., to passivate) on a front surface 32 of the first photovoltaic cell 22. Additionally, the optical properties of the window material must be such that as much light as possible is transmitted to the first photovoltaic cell 22, and any additional photoactive subcell layers that may be disposed underneath thereof (not shown), where the photogenerated charge carriers may be collected more efficiently. If there is substantial light absorption in the window layer 28, carriers generated in the window layer are less likely to be subsequently collected and hence light absorption in the window degrades overall conversion efficiency.

The semiconductor device 10 may optionally include an antireflection (AR) layer or coating (not shown) disposed on the front surface 32 of the semiconductor device 10 nearest the incident light L, which is shown impinging from the direction indicated by the arrows. In one embodiment, the AR coating may be disposed atop the window layer 28. The AR coating may reduce surface reflections between the optically transparent media above the semiconductor device 10 (such as air, glass, or polymer) and various semiconductor layers of the semiconductor device 10, thereby enabling more photons to enter the semiconductor device 10. The AR coating may be constructed of materials such as, for example, titanium dioxide (TiO₂), tantalum pentoxide (Ta₂O₅), silicon dioxide (SiO₂), and magnesium fluoride (MgF₂). The thickness of the AR coating may vary, but may range between about 0.04 and 0.35 microns. While an AR coating can be applied to the semiconductor device 10, in other embodiments another subcell may be stacked or applied above the semiconductor device 10.

The first photovoltaic cell 22 may further include a p-doped back surface field (BSF) layer 34 disposed on a bottom surface 36 of the first emitter and base 20. In the exemplary embodiment as illustrated, the p-doped BSF layer 34 is a p-doped InP BSF layer. In another embodiment, the p-doped BSF layer 34 may be an AlGaInAs, GaAsSb, AlAsSb, AlGaAsSb, AlInAs, GaInPAs and their alloys layer. In one embodiment, the BSF layer 34 is lattice-matched to InP. In another embodiment, the BSF layer 34 may be a coherently strained layer with a thickness below a Matthews-Blakeslee critical thickness.

The second photovoltaic cell 24 includes a second emitter and base 40. In the exemplary embodiment as shown, the second emitter and base 40 is a GaInPAs layer having an InP lattice constant. The second emitter and base 40 is a material layer selected from group consisting of: GaInAs, GaAsSb, AlGaInAs, AlGaAsSb, GaInPAs and their alloys having an InP lattice constant. The second emitter and base 40 has a bandgap lower than the bandgap of the first emitter and base 20.

In the exemplary embodiment as shown in FIG. 1, the second photovoltaic cell 24 has a bandgap of about 0.8 eV. In another embodiment, the second photovoltaic cell 24 may have a bandgap of from about 0.73 to 2.0 eV. In yet another embodiment, the second photovoltaic cell 24 may have a bandgap of from about 0.73 to 0.8 eV and be included in a three or more junction solar cell lattice-matched to InP.

The second photovoltaic cell may 24 further include a n-doped window layer 42 disposed on a top surface 44 of the second emitter and base 40. In general, the characteristics of the n-doped window layer 42 are similar to the window characteristics of the window layer 28. The n-doped window 42 may include a n-doping concentration of between about 2×10¹⁸/cm³ and 2×10¹⁹/cm³. In another embodiment, the n-doped window 42 has a n-doping concentration of about 1 ×10¹⁹/cm³ to create a relatively large electric field and to passivate the p-n junction.

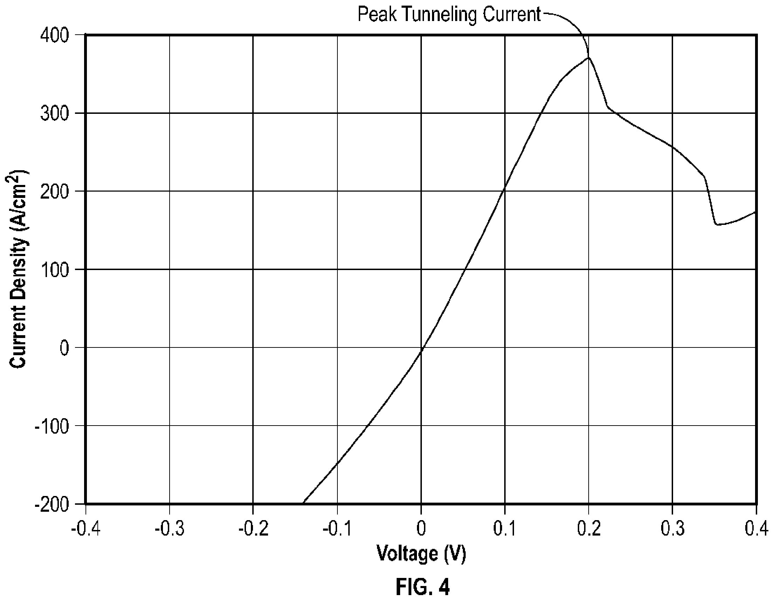

The second photovoltaic cell 24 may further include a second BSF layer 48 below the second emitter and base 40, which is similar to the BSF layer 34. The tunnel junction 26 may electrically connect the first photovoltaic cell 22 and the second photovoltaic cell 24 together with one another in electrical series. It should also be appreciated that the tunnel junction 26 is a type-II tunnel junction, which reduces the tunneling energy barrier within the tunnel junction 26. This in turn increases tunneling probability as well as the peak tunneling current of the tunnel junction 26. For example, as seen in FIG. 4, in one embodiment the tunnel junction 26 may include a peak tunneling current of 372 A/cm² and a specific resistance of 0.55 mΩ-cm². Furthermore, as explained in greater detail below, both layers of the tunnel junction 26 may be doped at relatively high levels.

In the embodiment as shown in FIG. 1, the tunnel junction 26 includes a p-doped tunnel layer 60 and a n-doped tunnel layer 62. The p-doped tunnel layer 60 is constructed of aluminum gallium arsenide antimonide (AlGaAsSb). The p-doped tunnel layer 60 may be doped with relatively high levels of carbon (i.e., C-doping or carbon doping). Thatis, the p-doped tunnel layer 60 may include a C-doping concentration ranging from about 10¹⁹/cm³ to 2×10²⁰/cm³. It is to be appreciated that carbon doping employs dopants that include relatively low diffusion coefficients, thereby resulting in relatively stable doping profiles and tunnel juction performance. However, an indium-based material such as, for example, an InAlGaAs layer may be challenging to dope because indium precursors may inhibit the incorporation of carbon dopants.

It should also be appreciated that the p-doped tunnel layer 60 may be lattice-matched with the p-doped InP BSF layer 34. The inclusion of antimonide in the p-doped tunnel layer 60 allows for lattice-matching with the p-doped InP BSF layer 34. Furthermore, the inclusion of aluminium within the p-doped tunnel layer 60 results in a relatively high bandgap (i.e., transparency) and a low level of light absorption. A relatively high bandgap may be any value greater than about 0.73 eV. In one embodiment, the p-doped tunnel layer 60 may include bandgap ranging from about 0.7 to about 1.4 eV.

The n-doped tunnel layer 62 is also lattice-matched to InP. The n-doped tunnel layer 62 is high bandgap III-V semiconductor having an InP lattice constant and that forms type II band alignment with the p-doped tunnel layer 60. The n-doped tunnel layer 62 is a highly n-doped aluminium indium phosphide arsenide (AlInPAs) tunnel layer having a bandgap greater than or equal to 1.35 eV and an InP lattice constant. In one embodiment, not forming part of the claimed present invention, the n-doped tunnel layer 62 is an InP tunnel layer having a bandgap of 1.35 eV. The n-doped tunnel layer 62 may be doped with relatively high levels of silicon or tellurium (i.e., Si or Te-doping). That is, the n-doped tunnel layer 62 may include an Si or Te-doping concentration of at least about 10¹⁹/cm³.

In one embodiment, the p-doped tunnel layer 60 and the n-doped tunnel layer 62 may be grown sequentially in a metalorganic vapor phase epitaxy (MOVPE) reactor. Furthermore, the semiconductor device 10 as well as various device components (e.g., the window, BSF) are grown in a MOVPE reactor. In another embodiment, the tunnel junction 26 may be grown in a chemical beam epitaxy (CBE), hydride vapor phase epitaxy (HVPE) or atomic layer deposition (ALD) reactor. In the embodiment as shown in FIG. 1, the semiconductor device 10 is an upright solar cell configuration where new layers are grown just above a prior layer, and the highest bandgap layer is grown last. In another embodiment, the semiconductor device 10 may be inverted, where the highest bandgap layer is grown first.

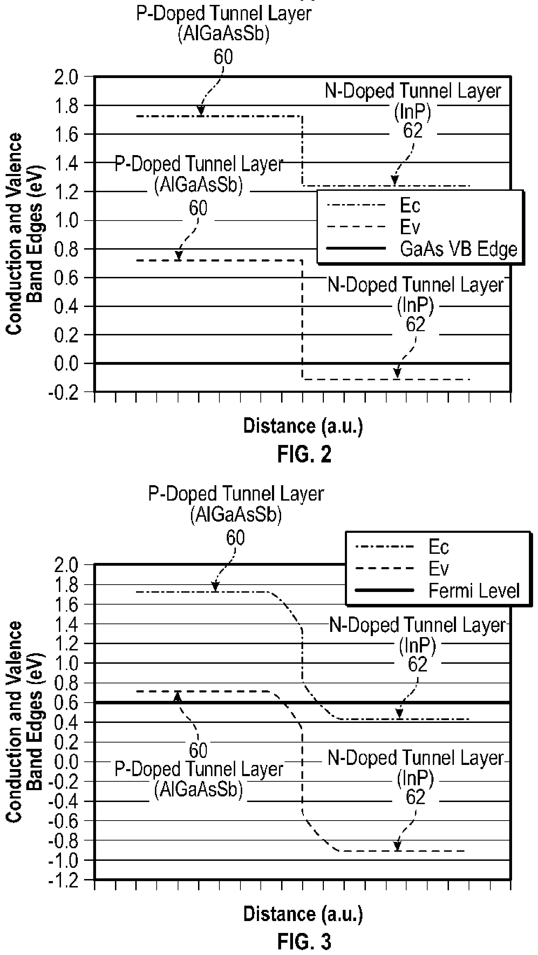

FIG. 2 is an illustration of an exemplary band offset diagram for the disclosed tunnel junction 26 not forming part of the claimed present invention, and FIG. 3 is the band offset diagram shown in FIG. 2 after thermal equilibrium. The band offset diagrams shown in FIGS. 2-3 illustrate a valence band Eᵥ and a conduction band E_{c} of both the p-doped tunnel layer 60 as well as the n-doped tunnel layer 62 of the tunnel junction 26, as well as a valence band (VB) edge. In the exemplary embodiment as described, the p-doped tunnel layer 60 includes a 20% concentration of aluminium (i.e., x = 0.20). Turning to FIG. 3 at thermal equilibrium, after carrier diffusion, it can be seen that both the valence band Eᵥ and the conduction band E_{c} both bend between the p-doped tunnel layer 60 and the n-doped tunnel layer 62. Joining the p-doped tunnel layer 60 and the n-doped tunnel layer 62 creates a staggered gap (type II) heterostructure. Indeed, as seen in FIGS. 3 and 4, both the valence band Eᵥ and the conduction band E_{c} of the n-doped tunnel layer 62 are lower in energy when compared to the p-doped tunnel layer 60. A heterojunction includes two or more semiconductor materials that are grown on one another, and a heterostructure includes the heterojunction. It should be appreciated that a type II heterostructure results in a lower effective energy barrier for tunneling.

FIG. 4 is a graph illustrating measured characteristics for an exemplary tunnel junction 26 after annealing. Specifically, the tunnel junction 26 was exposed to a thirty minute anneal at temperatures comparable to those experienced for active junction growth. It should be appreciated that there was negligible or no change in performance of the tunnel junction 26 before or after annealing, which is an indication that the dopants used for both the p-doped tunnel layer 60 and the n-doped tunnel layer 62 (FIG. 1) do not readily diffuse. As seen in FIG. 3, the tunnel junction 26 may include a peak tunneling current of 372 A/cm² and a specific resistance of 0.55 mΩ-cm². The peak tunneling current is equivalent to a solar cell operating at more than 30,000 suns, which is well in excess of a practical concentration.

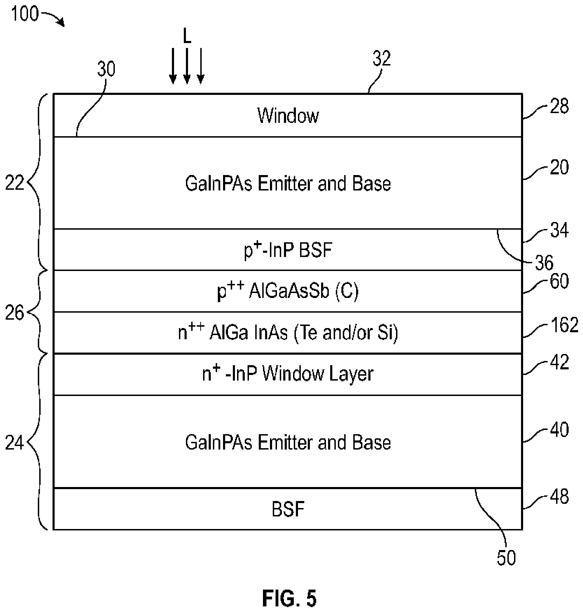

FIG. 5 is an alternative embodiment of a semiconductor device 100, not forming part of the claimed present invention. The semiconductor device 100 includes a similar structure as the device shown in FIG. 1, except that a n-doped tunnel layer 162 is now constructed of AlGaInAs instead of InP. Thus, it is to be appreciated that the semiconductor device 100 retains the relatively high bandgap and the low level of light absorption of the p-doped tunnel layer 60 as described above and illustrated in FIG. 1. The n-doped tunnel layer 162 may be doped with relatively high levels of silicon, tellurium, or a combination of both materials. That is, the n-doped tunnel layer 62 may include a doping concentration of at least about 10¹⁹/cm³ of silicon, tellurium, or a combination of both materials.

It is to be appreciated that the n-doped tunnel layer 162 may include a lower bandgap and a higher light absorbance than the n-doped tunnel layer 62 ( FIG. 1 ); however the lower bandgap of the n-doped tunnel layer 162 reduces the energy barrier to tunneling, which in turn exponentially increases the probability of tunneling and tunneling current density. Specifically, in one embodiment, the n-doped tunnel layer 162 may include a bandgap of about 0.73 eV. Furthermore, light absorption of the n-doped tunnel layer 162 may be mitigated by reducing the thickness of the n-doped tunnel layer, and by decreasing the Al content. Specifically, in one embodiment the thickness of the tunnel junction 26 may be reduced to a minimum of about 10 nm, and the amount of aluminium in the n-doped tunnel layer 162 may range from about zero (i.e., negligible amounts) to about 50%.

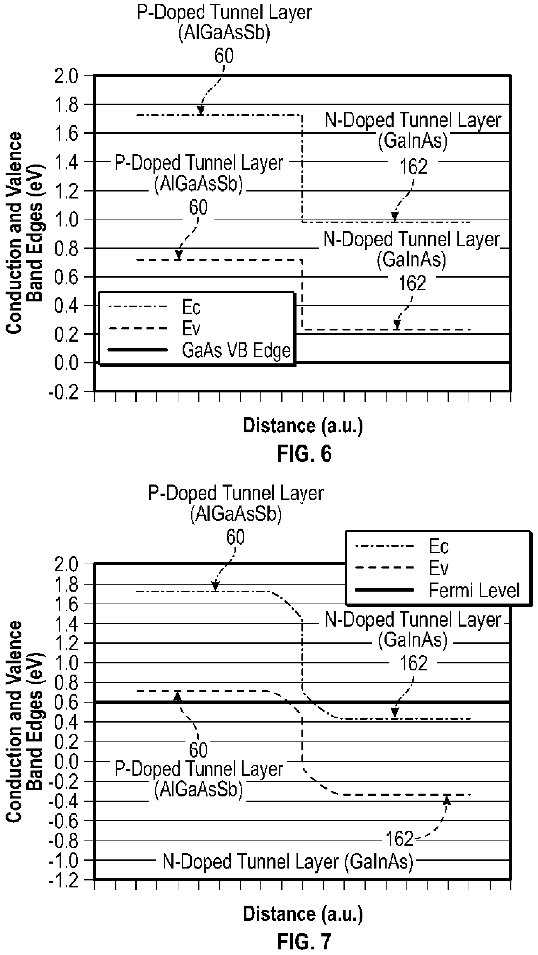

FIG. 6 is an illustration of an exemplary band offset diagram for the disclosed tunnel junction 26 shown in FIG. 5 , and FIG. 7 is the band offset diagram shown in FIG. 7 after thermal equilibrium. In the exemplary embodiment as described, the p-doped tunnel layer 60 includes a 20% concentration of aluminium (i.e., x = 0.20), and the n-doped tunnel layer 162 is constructed of GaInAs. However, it is to be understood that aluminium may be added to the n-doped tunnel layer 162 to create an n+ AlGaInAs layer as well.

Referring generally to the figures, the disclosed tunnel junction includes the p-doped tunnel layer constructed of AlGaAsSb, which demonstrates improved performance characteristics when compared to some other tunnel junctions currently available. Specifically, the disclosed p-doped layer may be easier to grow, since AlGaAsSb may be doped more heavily with carbon. In contrast, compounds containing a high amount of indium are typically challenging to dope. In fact, a p-doped InAlGaAs layer may only be capable of being doped to the level of about 1018 /cm3 , and even this level of doping may be challenging. Furthermore, the disclosed tunnel junction also exhibits relatively high peak tunneling currents. Finally, it should also be appreciated that the disclosed p-doped tunnel layer constructed of AlGaAsSb also exhibits a higher bandgap (i.e., transparency) than some other types of tunnel junctions currently available. Finally, it is to be appreciated that high transparency is especially important in applications where the tunnel junction is placed in the upper portion of a solar cell that is located closer to incident light (i.e., the sun).

Also provided are the following illustrative, non-exhaustive examples encompassed herein:

The tunnel junction may have the p-doped tunnel layer doped with carbon.

The tunnel junction may have the p-doped tunnel layer that includes a carbon concentration ranging from about 10¹⁹/cm³ to 10²⁰/cm³.

The tunnel junction may have the p-doped tunnel layer that includes bandgap ranging from about 0.7 to about 1.4 eV.

The tunnel junction may have the n-doped tunnel layer that is doped with a material selected from a group consisting of: silicon and tellurium.

The tunnel may have the n-doped tunnel layer that includes a silicon concentration or a tellurium concentration of at least about 10¹⁹/cm³.

The tunnel junction may have the n-doped tunnel layer that is doped with at least one of silicon and tellurium.

A semiconductor solar cell device may have the p-doped tunnel layer that includes a carbon concentration ranging from about 10¹⁹/cm³ to 10²⁰/cm³.

The semiconductor solar cell device may have the p-doped tunnel layer that includes a bandgap ranging from about 0.7 to about 1.4 eV.

The semiconductor solar cell device may have the n-doped tunnel layer that is doped with a material selected from a group consisting of: silicon and tellurium.

The semiconductor solar cell device may have the n-doped tunnel layer that includes a silicon concentration or a tellurium concentration of at least about 10¹⁹ /cm³.

The semiconductor solar cell device may have the n-doped tunnel layer that is doped with at least one of silicon and tellurium.

A method may comprise doping the p-doped tunnel layer with carbon.

The method may include that the n-doped tunnel layer and the p-doped tunnel layer are grown sequentially in a reactor selected from the group consisting of a: metalorganic vapor phase epitaxy (MOVPE) reactor, a chemical beam epitaxy (CBE) reactor, a hydride vapor phase epitaxy (HVPE) reactor and an atomic layer deposition (ALD) reactor.

While the forms of apparatus and methods herein described constitute preferred embodiments of this present invention, it is to be understood that the present invention is not limited to these precise forms of apparatus and methods, and that changes may be made therein without departing from the scope of the appended claims.

## Claims

1. A semiconductor solar cell device (10), wherein the solar cell is an indium-phosphide-based dual-junction solar cell that comprises:
a first photovoltaic cell (22) including a first emitter and base (20), wherein said first emitter and base (20) is a material layer selected from group consisting of: indium gallium arsenide phosphide, GaInPAs, aluminum arsenide antimonide, AlAsSb, aluminum gallium arsenide antimonide, AlGaAsSb, aluminum indium arsenide, AlInAs, indium phosphide, InP, aluminum gallium indium arsenide, AlGaInAs, gallium indium arsenide, GaInAs, or gallium arsenide antimonide, GaAsSb;
a second photovoltaic cell (24) including a second emitter and base (40), wherein said second emitter and base (40) has a lower bandgap than the bandgap of said first emitter and base (20), wherein said second emitter and base (40) is a material layer selected from group consisting of: gallium indium arsenide, GaInAs, gallium arsenide antimonide, GaAsSb, aluminum gallium arsenide antimonide, AlGaAsSb, aluminum gallium indium arsenide, AlGaInAs, gallium indium phosphide arsenide, GaInPAs, and their alloys having an InP lattice constant, and,
a tunnel junction (26) located between the first and second photovoltaic cells and the tunnel junction comprising
an n-doped tunnel layer (62), wherein the n-doped tunnel layer is constructed of aluminum indium phosphide arsenide, AlInPAs; and
a p-doped tunnel layer (60), wherein the p-doped tunnel layer is constructed of aluminum gallium arsenide antimonide, AlGaAsSb.

2. The device of claim 1, wherein the p-doped tunnel layer (60) is doped with carbon.

3. The device of claim 2, wherein the p-doped tunnel layer (60) includes a carbon concentration ranging from about 10¹⁹/cm³ to 2×10²⁰/cm³.

4. The device of any one of claims 1-2, wherein the p-doped tunnel layer (60) includes bandgap ranging from about 0.7 to about 1.4 eV.

5. The device of any one of claims 1-4, wherein the n-doped tunnel layer (62) is doped with a material selected from a group consisting of: silicon and tellurium.

6. The device of claim 5, wherein the n-doped tunnel (62) layer includes a silicon concentration or a tellurium concentration of at least about 10¹⁹/cm³.

7. The device (10) according to any of claims 1-6, wherein said first photovoltaic cell (22) further includes a p-doped back surface field (BSF) layer (34) disposed on a bottom surface (36) of the first emitter and base (20).

8. The device (10) of any of claims 1-7, wherein said first photovoltaic cell (22) further includes a window layer (28) disposed on a first side (30) of said first emitter and base (20) positioned nearest to incident light (L).

9. The device (10) of any of claims 1-8, wherein said second photovoltaic cell (24) further includes a n-doped window layer (42) disposed on a top surface (44) of the second emitter and base (40).

10. The device according to any preceding claim, wherein the p-doped tunnel layer is constructed of aluminum gallium arsenide antimonide (AlGaAsSb) with a concentration of aluminum of 20%.

11. A method of constructing the semiconductor solar cell device (10) of claim 1, the method comprising:
growing a first photovoltaic cell (22) including a first emitter and base (20), wherein said first emitter and base (20) is a material layer selected from group consisting of: indium gallium arsenide phosphide, GaInPAs, aluminum arsenide antimonide, AlAsSb, aluminum gallium arsenide antimonide, AlGaAsSb, aluminum indium arsenide, AlInAs, indium phosphide, InP, aluminum gallium indium arsenide, AlGaInAs, gallium indium arsenide, GaInAs, or gallium arsenide antimonide, GaAsSb;
growing a n-doped tunnel layer (62), wherein the n-doped tunnel layer (62) is constructed of aluminum indium phosphide arsenide, AlInPAs;
growing a p-doped tunnel layer (60), wherein the p-doped tunnel layer (60) is constructed of aluminum gallium arsenide antimonide, AlGaAsSb, and
growing a second photovoltaic cell (24) including a second emitter and base (40), wherein said second emitter and base (40) has a lower bandgap than the bandgap of said first emitter and base (20), wherein said second emitter and base (40) is a material layer selected from group consisting of: gallium indium arsenide, GalnAs, gallium arsenide antimonide, GaAsSb, aluminum gallium arsenide antimonide, AlGaAsSb, aluminum gallium indium arsenide, AlGaInAs, gallium indium phosphide arsenide, GaInPAs, and their alloys having an InP lattice constant.

12. The method as recited in claim 11, comprising doping the p-doped tunnel layer (60) with carbon.

13. The method as recited in any one of claims 11-12, wherein the n-doped tunnel layer (62) and the p-doped tunnel layer (60) are grown sequentially in a reactor selected from the group consisting of a: metalorganic vapor phase epitaxy, MOVPE, reactor, a chemical beam epitaxy, CBE, reactor, a hydride vapor phase epitaxy, HVPE, reactor and an atomic layer deposition, ALD, reactor.

14. The method of any of claims 11-13, wherein the n-doped tunnel layer (62) is doped with a material selected from a group consisting of: silicon and tellurium.

15. The method of claim 14, wherein the n-doped tunnel (62) layer includes a silicon concentration or a tellurium concentration of at least about 10¹⁹/cm³.

## Patentansprüche

1. Halbleiter-Solarzellenvorrichtung (10), wobei die Solarzelle eine Solarzelle auf Indium-Phosphid-Basis mit zwei Übergängen ist, die aufweist:
eine erste photovoltaische Zelle (22) mit einem ersten Emitter und Basis (20), wobei der erste Emitter und Basis (20) eine Materialschicht ist, die ausgewählt ist aus der Gruppe bestehend aus: Indium-Gallium-Arsenid-Phosphid, GalnPAs, Aluminium-Arsenid-Antimonid, AlAsSb, Aluminium-Gallium-Arsenid-Antimonid, AlGaAsSb, Aluminium-Indium-Arsenid, AlInAs, Indium-Phosphid, InP, Aluminium-Gallium-Indium-Arsenid, AlGalnAs, Gallium-Indium-Arsenid, GalnAs, oder Gallium-Arsenid-Antimonid, GaAsSb;
eine zweite photovoltaische Zelle (24) mit einem zweiten Emitter und Basis (40), wobei der zweite Emitter und Basis (40) eine geringere Bandlücke als die Bandlücke des ersten Emitters und Basis (20) aufweist, wobei der zweite Emitter und Basis (40) eine Materialschicht ist, die ausgewählt ist aus der Gruppe bestehend aus: Gallium-Indium-Arsenid, GalnAs, Gallium-Arsenid-Antimonid, GaAsSb, Aluminium-Gallium-Arsenid-Antimonid, AlGaAsSb, Aluminium-Gallium-Indium-Arsenid, AlGalnAs, Gallium-Indium-Phosphid-Arsenid, GalnPAs, und deren Legierungen mit einer InP-Gitterkonstante, und
einen Tunnelübergang (26), der sich zwischen der ersten und der zweiten photovoltaischen Zelle befindet, und wobei der Tunnelübergang ausweist:
eine n-dotierte Tunnelschicht (62), wobei die n-dotierte Tunnelschicht aus Aluminium-Indium-Phosphid-Arsenid, AlInPAs, aufgebaut ist; und
. eine p-dotierte Tunnelschicht (60), wobei die p-dotierte Tunnelschicht aus Aluminium-Gallium-Arsenid-Antimonid, AlGaAsSb, aufgebaut ist.

2. Vorrichtung nach Anspruch 1, wobei die p-dotierte Tunnelschicht (60) mit Kohlenstoff dotiert ist.

3. Vorrichtung nach Anspruch 2, wobei die p-dotierte Tunnelschicht (60) eine Kohlenstoffkonzentration im Bereich von etwa 10¹⁹/cm³ bis 2×10²⁰/cm³ aufweist.

4. Vorrichtung nach einem der Ansprüche 1 bis 2, wobei die p-dotierte Tunnelschicht (60) eine Bandlücke im Bereich von etwa 0,7 bis etwa 1,4 eV aufweist.

5. Vorrichtung nach einem der Ansprüche 1 bis 4, wobei die n-dotierte Tunnelschicht (62) mit einem Material dotiert ist, das aus einer Gruppe ausgewählt ist, die aus Silizium und Tellur besteht.

6. Vorrichtung nach Anspruch 5, wobei die n-dotierte Tunnelschicht (62) eine Siliziumkonzentration oder eine Tellurkonzentration von mindestens etwa 10¹⁹/cm³ aufweist.

7. Vorrichtung (10) nach einem der Ansprüche 1 bis 6, wobei die erste photovoltaische Zelle (22) ferner eine p-dotierte Rückseitenfeld- (BSF) Schicht (34) aufweist, die auf einer Bodenfläche (36) des ersten Emitters und Basis (20) angeordnet ist.

8. Vorrichtung (10) nach einem der Ansprüche 1 bis 7, wobei die erste photovoltaische Zelle (22) ferner eine Fensterschicht (28) aufweist, die auf einer ersten Seite (30) des ersten Emitters und Basis (20) angeordnet ist, die zu einfallendem Licht (L) am nächsten angeordnet ist.

9. Vorrichtung (10) nach einem der Ansprüche 1 bis 8, wobei die zweite photovoltaische Zelle (24) ferner eine n-dotierte Fensterschicht (42) aufweist, die auf einer Oberseite (44) des zweiten Emitters und Basis (40) angeordnet ist.

10. Vorrichtung nach einem der vorhergehenden Ansprüche, wobei die p-dotierte Tunnelschicht aus Aluminium-Gallium-Arsenid-Antimonid (AlGaAsSb) mit einer Aluminiumkonzentration von 20 % aufgebaut ist.

11. Verfahren zum Herstellen der Halbleiter-Solarzellenvorrichtung (10) nach Anspruch 1, wobei das Verfahren aufweist:
Züchten einer ersten photovoltaischen Zelle (22) mit einem ersten Emitter und Basis (20), wobei der erste Emitter und Basis (20) eine Materialschicht ist, die ausgewählt ist aus der Gruppe bestehend aus: Indium-Gallium-Arsenid-Phosphid, GalnPAs, Aluminium-Arsenid-Antimonid, AlAsSb, Aluminium-Gallium-Arsenid-Antimonid, AlGaAsSb, Aluminium-Indium-Arsenid, AlInAs, Indium-Phosphid, InP, Aluminium-Gallium-Indium-Arsenid, AlGalnAs, Gallium-Indium-Arsenid, GaInAs, oder Gallium-Arsenid-Antimonid, GaAsSb;
Züchten einer n-dotierten Tunnelschicht (62), wobei die n-dotierte Tunnelschicht (62) aus Aluminium-Indium-Phosphid-Arsenid, AlInPAs, aufgebaut ist
Züchten einer p-dotierten Tunnelschicht (60), wobei die p-dotierte Tunnelschicht (60) aus Aluminium-Gallium-Arsenid-Antimonid, AlGaAsSb, aufgebaut ist, und
Züchten einer zweiten photovoltaischen Zelle (24) mit einem zweiten Emitter und Basis (40), wobei der zweite Emitter und Basis (40) eine geringere Bandlücke als die Bandlücke des ersten Emitters und Basis (20) aufweist, wobei der zweite Emitter und Basis (40) eine Materialschicht ist, die ausgewählt ist aus der Gruppe bestehend aus: Gallium-Indium-Arsenid, GalnAs, Gallium-Arsenid-Antimonid, GaAsSb, Aluminium-Gallium-Arsenid-Antimonid, AlGaAsSb, Aluminium-Gallium-Indium-Arsenid, AlGalnAs, Gallium-Indium-Phosphid-Arsenid, GalnPAs, und deren Legierungen mit einer InP-Gitterkonstante.

12. Verfahren nach Anspruch 11, das ein Dotieren der p-dotierten Tunnelschicht (60) mit Kohlenstoff aufweist.

13. Verfahren nach einem der Ansprüche 11 bis 12, bei dem die n-dotierte Tunnelschicht (62) und die p-dotierte Tunnelschicht (60) nacheinander in einem Reaktor gezüchtet werden, der ausgewählt ist aus der Gruppe bestehend aus einem metallorganischen Gasphasenepitaxie, MOVPE, Reaktor, einem chemischen Strahlenepitaxie, CBE, Reaktor, einem Hydrid-Gasphasenepitaxie, HVPE, Reaktor und einem Atomlagenabscheidung, ALD, Reaktor.

14. Verfahren nach einem der Ansprüche 11 bis 13, wobei die n-dotierte Tunnelschicht (62) mit einem Material dotiert ist, das aus einer Gruppe ausgewählt ist, die aus Silizium und Tellur besteht.

15. Verfahren nach Anspruch 14, wobei die n-dotierte Tunnelschicht (62) eine Siliziumkonzentration oder eine Tellurkonzentration von mindestens etwa 10¹⁹/cm³ aufweist.

## Revendications

1. Dispositif de cellule solaire à semi-conducteurs (10), dans lequel la cellule solaire est une cellule solaire à double jonction à base de phosphure d'indium qui comprend :
une première cellule photovoltaïque (22) incluant des premiers émetteur et base (20), dans lequel lesdits premiers émetteur et base (20) sont une couche de matériau sélectionnée parmi un groupe constitué de : indium gallium arséniure phosphure, GaInPAs, aluminium arséniure antimoniure, AlAsSb, aluminium gallium arséniure antimoniure, AlGaAsSb, aluminium indium arséniure, AlInAs, indium phosphure, InP, aluminium gallium indium arséniure, AlGaInAs, gallium indium arséniure, GaInAs, ou gallium arséniure antimoniure, GaAsSb ;
une seconde cellule photovoltaïque (24) comportant des seconds émetteur et base (40), dans lequel lesdits seconds émetteur et base (40) présentent une bande interdite inférieure à la bande interdite desdits premiers émetteur et base (20), dans lequel lesdits seconds émetteur et base (40) sont une couche de matériau sélectionné parmi un groupe constitué de : gallium indium arséniure, GaInAs, gallium arséniure antimoniure, GaAsSb, aluminium gallium arséniure antimoniure, AlGaAsSb, aluminium gallium indium arséniure, AlGaInAs, gallium indium phosphure arséniure, GaInPAs, et leurs alliages présentant une constante de réseau d'InP, et,
une jonction à effet tunnel (26) située entre les première et seconde cellules photovoltaïques et la jonction à effet tunnel comprenant :
une couche de tunnel à dopage de type n (62), dans lequel la couche de tunnel à dopage de type n est composée d'aluminium indium phosphure arséniure, AlInPAs ; et
une couche de tunnel à dopage de type p (60), dans lequel la couche de tunnel à dopage de type p est composée d'aluminium gallium arséniure antimoniure, AlGaAsSb.

2. Dispositif selon la revendication 1, dans lequel la couche de tunnel à dopage de type p (60) est dopée avec du carbone.

3. Dispositif selon la revendication 2, dans lequel la couche de tunnel à dopage de type p (60) comporte une concentration de carbone dans la plage d'environ 10¹⁹/cm³ à 2×10²⁰/cm³.

4. Dispositif selon l'une quelconque des revendications 1-2, dans lequel la couche de tunnel à dopage de type p (60) comporte une bande interdite dans la plage d'environ 0,7 à environ 1,4 eV.

5. Dispositif selon l'une quelconque des revendications 1-4, dans lequel la couche de tunnel à dopage de type n (62) est dopée avec un matériau sélectionné parmi un groupe composé de : silicium et tellure.

6. Dispositif selon la revendication 5, dans lequel la couche de tunnel à dopage de type n (62) comporte une concentration de silicium ou une concentration de tellure d'au moins environ 10¹⁹/cm³.

7. Dispositif (10) selon l'une quelconque des revendications 1-6, dans lequel ladite première cellule photovoltaïque (22) comporte en outre une couche de champ électrique arrière à dopage de type p (BSF) (34) disposée sur une surface inférieure (36) des premiers émetteur et base (20).

8. Dispositif (10) selon l'une quelconque des revendications 1-7, dans lequel ladite première cellule photovoltaïque (22) comporte en outre une couche de fenêtre (28) disposée sur un premier côté (30) desdits premiers émetteur et base (20) positionnés le plus près d'une lumière incidente (L).

9. Dispositif (10) selon l'une quelconque des revendications 1-8, dans lequel ladite seconde cellule photovoltaïque (24) comporte en outre une couche de fenêtre à dopage de type n (42) disposée sur une surface supérieure (44) des seconds émetteur et base (40).

10. Dispositif selon une quelconque revendication précédente, dans lequel la couche de tunnel à dopage de type p est composée d'aluminium gallium arséniure antimoniure (AlGaAsSb) avec une concentration d'aluminium de 20 %.

11. Procédé de construction du dispositif de cellule solaire à semi-conducteurs (10) selon la revendication 1, le procédé comprenant :
la croissance d'une première cellule photovoltaïque (22) comportant des premiers émetteur et base (20), dans lequel lesdits premiers émetteur et base (20) sont une couche de matériau sélectionnée parmi un groupe constitué de : indium gallium arséniure phosphure, GaInPAs, aluminium arséniure antimoniure, AlAsSb, aluminium gallium arséniure antimoniure, AlGaAsSb, aluminium indium arséniure, AlInAs, indium phosphure, InP, aluminium gallium indium arséniure, AlGaInAs, gallium indium arséniure, GaInAs, ou gallium arséniure antimoniure, GaAsSb ;
la croissance d'une couche de tunnel à dopage de type n (62), dans lequel la couche de tunnel à dopage de type n (62) est composée d'aluminium indium phosphure arséniure, AlInPAs ;
la croissance d'une couche de tunnel à dopage de type p (60), dans lequel la couche de tunnel à dopage de type p (60) est composée d'aluminium gallium arséniure antimoniure, AlGaAsSb, et
la croissance d'une seconde cellule photovoltaïque (24) comportant des seconds émetteur et base (40), dans lequel lesdits seconds émetteur et base (40) présentent une bande interdite inférieure à la bande interdite desdits premiers émetteur et base (20), dans lequel lesdits seconds émetteur et base (40) sont une couche de matériau sélectionnée parmi un groupe constitué de : gallium indium arséniure, GaInAs, gallium arséniure antimoniure, GaAsSb, aluminium gallium arséniure antimoniure, AlGaAsSb, aluminium gallium indium arséniure, AlGaInAs, gallium indium phosphure arséniure, GaInPAs, et leurs alliages présentant une constante de réseau d'InP.

12. Procédé selon la revendication 11, comprenant le dopage de la couche de tunnel à dopage de type p (60) avec du carbone.

13. Procédé selon l'une quelconque des revendications 11-12, dans lequel la couche de tunnel à dopage de type n (62) et la couche de tunnel à dopage de type p (60) sont amenées à croître séquentiellement dans un réacteur sélectionné à partir du groupe constitué de : un réacteur d'épitaxie en phase vapeur aux organométalliques, MOVPE, un réacteur d'épitaxie par faisceaux chimiques, CBE, un réacteur d'épitaxie en phase vapeur hybride, HVPE, et un réacteur de dépôt de couche atomique, ALD.

14. Procédé selon l'une quelconque des revendications 11-13, dans lequel la couche de tunnel à dopage de type n (62) est dopée avec un matériau sélectionné à partir d'un groupe constitué de : silicium et tellure.

15. Procédé selon la revendication 14, dans lequel la couche de tunnel à dopage de type n (62) comporte une concentration de silicium ou une concentration de tellure d'au moins environ 10¹⁹/cm³.
